# EUROPEAN PATENT SPECIFICATION

(11) **EP 3 869 569 B1**
(45) Date of publication and mention of the grant of the patent: **01.03.2023**
(21) Application number: 18936944.0
(22) Date of filing: 15.10.2018
(51) Int. Cl.: H01L 31/054

(54) **SHIELD PLATE FOR CONCENTRATED SOLAR POWER GENERATION MODULE, CONCENTRATED SOLAR POWER GENERATION MODULE, AND METHOD OF MANUFACTURING CONCENTRATED SOLAR POWER GENERATION MODULE**
ABSCHIRMUNGSPLATTE FÜR KONZENTRIERTES SOLARENERGIEERZEUGUNGSMODUL, KONZENTRIERTES SOLARENERGIEERZEUGUNGSMODUL UND VERFAHREN ZUR HERSTELLUNG EINES KONZENTRIERTEN SOLARENERGIEERZEUGUNGSMODULS
PLAQUE DE BLINDAGE POUR MODULE DE GÉNÉRATION D'ÉNERGIE SOLAIRE CONCENTRÉE, MODULE DE GÉNÉRATION D'ÉNERGIE SOLAIRE CONCENTRÉE ET PROCÉDÉ DE FABRICATION DE MODULE DE GÉNÉRATION D'ÉNERGIE SOLAIRE CONCENTRÉE

(43) Date of publication of application: 25.08.2021
(73) Proprietor: Sumitomo Electric Industries, Ltd., Osaka-shi, Osaka 541-0041 (JP)
(72) Inventor: IMAI, Ryusuke, Osaka-shi, Osaka 541-0041 (JP); SAITO, Kenji, Osaka-shi, Osaka 541-0041 (JP); NAGAI, Youichi, Osaka-shi, Osaka 541-0041 (JP); UEYAMA, Munetsugu, Osaka-shi, Osaka 541-0041 (JP)
(74) Representative: Boult Wade Tennant LLP
(86) International application number: PCT/JP2018/038293
(87) International publication number: WO 2020/079727

(56) References cited:
- EP-A2- 2 294 629
- WO-A1-2006/070425
- JP-A- 2013 012 605
- JP-A- 2013 191 643
- JP-A- 2013 191 730
- US-A1- 2010 229 948
- US-A1- 2012 152 309
- US-A1- 2015 243 821

## Description

### TECHNICAL FIELD

The present disclosure relates to a shield plate for a concentrator photovoltaic power generation module, a concentrator photovoltaic power generation module, and a method of manufacturing a concentrator photovoltaic power generation module.

### BACKGROUND ART

A photovoltaic power generation apparatus that concentrates solar rays and converts solar rays into electric power has conventionally been developed. For example, Japanese Patent Laying-Open No. 2006-344698 (PTL 1) discloses such a concentrator photovoltaic power generation apparatus. PTL 1 discloses a light shield plate that cuts off solar rays in a region other than a light receiving region of a solar cell element. The light shield plate is provided with a transmission hole for transmission of concentrated solar rays to allow irradiation of the light receiving region of the solar cell element therewith. Another light shield in the prior art is known from US patent publication US 2015/243821 A1, wherein a shielding plate comprises transmission holes.

### CITATION LIST

### PATENT LITERATURE

PTL 1: Japanese Patent Laying-Open No. 2006-344698

### SUMMARY OF INVENTION

A shield plate for a concentrator photovoltaic power generation module according to the present disclosure is a shield plate that cuts off solar rays in a region other than a plurality of power generation elements included in the concentrator photovoltaic power generation module. The shield plate for the concentrator photovoltaic power generation module includes a main plate and a bent portion. The main plate includes a first surface and a second surface opposed to each other and has a quadrangular shape. The bent portion is bent to rise from each of four sides of a quadrangular shape of the main plate toward the first surface. The main plate is provided with a plurality of transmission holes that pass through from the first surface to the second surface, solar rays being transmitted through the plurality of transmission holes toward the plurality of power generation elements. The main plate is provided with a first insertion hole that passes through from the first surface to the second surface, the first insertion hole being larger in dimension than the plurality of transmission holes.

A concentrator photovoltaic power generation module according to the present disclosure includes the shield plate for the concentrator photovoltaic power generation module described above, the plurality of power generation elements, a wire, and a housing. The plurality of power generation elements are provided in correspondence with the plurality of transmission holes, respectively. The wire is electrically connected to the plurality of power generation elements. The shield plate for the concentrator photovoltaic power generation module, the plurality of power generation elements, and the wire are accommodated in the housing.

A method of manufacturing a concentrator photovoltaic power generation module according to the present disclosure is a method of manufacturing the concentrator photovoltaic power generation module described above, and includes steps below.

The shield plate for the concentrator photovoltaic power generation module is supported with a support rod by inserting the support rod into the first insertion hole in the shield plate for the concentrator photovoltaic power generation module. The shield plate for the concentrator photovoltaic power generation module is removed from the support rod and arranged in the inside of the housing.

### BRIEF DESCRIPTION OF DRAWINGS

Fig. 1 is a perspective view showing a construction of a photovoltaic power generation apparatus in one embodiment.
Fig. 2 is an exploded perspective view showing a construction of a concentrator photovoltaic power generation module in one embodiment included in the concentrator photovoltaic power generation apparatus shown in Fig. 1.
Fig. 3 is an assembly cross-sectional view showing the construction of the concentrator photovoltaic power generation module in one embodiment included in the concentrator photovoltaic power generation apparatus shown in Fig. 1.
Fig. 4 is a plan view showing a construction of a shield plate for the concentrator photovoltaic power generation module in one embodiment included in the concentrator photovoltaic power generation module shown in Fig. 2.
Fig. 5 is a partially enlarged plan view of a region RB in Fig. 4.
Fig. 6 is a partially enlarged plan view of a region RA in Fig. 4.
Fig. 7 is a perspective view showing a first step in a method of manufacturing the concentrator photovoltaic power generation module in one embodiment.
Fig. 8 is a side view showing the first step in the method of manufacturing the concentrator photovoltaic power generation module in one embodiment.
Fig. 9 is a cross-sectional view showing a second step in the method of manufacturing the concentrator photovoltaic power generation module in one embodiment.
Fig. 10 is a cross-sectional view for illustrating a problem in a comparative example in which shield plates for a concentrator photovoltaic power generation module are vertically layered.
Fig. 11 is a cross-sectional view for illustrating a problem in accommodating in the inside of a housing, the shield plate for the concentrator photovoltaic power generation module in the comparative example shown in Fig. 10.

### DETAILED DESCRIPTION

### [Problem to be Solved by the Present Disclosure]

With increase in size of a concentrator photovoltaic power generation module, vertical and lateral dimensions of a shield plate also increase. The shield plate is relatively small in thickness. Therefore, the shield plate tends to warp with increase in vertical and lateral dimensions. With increase in size of the shield plate, accordingly, works for assembling the shield plate to a housing become difficult.

An object of the present disclosure is to provide a shield plate for a concentrator photovoltaic power generation module that is readily assembled to a housing, a concentrator photovoltaic power generation module, and a method of manufacturing a concentrator photovoltaic power generation module.

### [Advantageous Effect of the Present Disclosure]

According to the present disclosure, a shield plate for a concentrator photovoltaic power generation module that is readily assembled to a housing, a concentrator photovoltaic power generation module, and a method of manufacturing a concentrator photovoltaic power generation module can be realized.

### [Description of Embodiment of the Present Disclosure]

The summary of an embodiment of the present disclosure will initially be listed and described.
(1) A shield plate 8 for a concentrator photovoltaic power generation module according to the present disclosure is a shield plate that cuts off solar rays in a region other than a plurality of power generation elements 3 included in a concentrator photovoltaic power generation module 10. Shield plate 8 for the concentrator photovoltaic power generation module includes a main plate 8a having a quadrangular shape and a bent portion 8b. Main plate 8a includes a first surface 8a1 and a second surface 8a2 opposed to each other. Bent portion 8b is bent to rise from each of four sides of a quadrangular shape of main plate 8a toward first surface 8a1. Main plate 8a is provided with a plurality of transmission holes 8c that pass through from first surface 8a1 to second surface 8a2, solar rays being transmitted through the plurality of transmission holes 8c toward the plurality of power generation elements 3. Main plate 8a is provided with a first insertion hole 8d1 that passes through from first surface 8a1 to second surface 8a2, first insertion hole 8d1 being larger in dimension than the plurality of transmission holes 8c.

According to shield plate 8 for the concentrator photovoltaic power generation module according to (1), bent portion 8b is provided. Bent portion 8b is bent to rise from each of the four sides of the quadrangular shape of main plate 8a toward first surface 8a1. By providing bent portion 8b, shield plate 8 according to the present disclosure can be higher in strength than a shield plate formed only from main plate 8a. Thus, even though shield plate 8 is made smaller in thickness and larger in size, shield plate 8 is less likely to warp. Therefore, shield plate 8 is readily assembled in housing 4.

Shield plate 8 according to the present disclosure is provided with first insertion hole 8d1. First insertion hole 8d1 passes through from first surface 8a1 to second surface 8a2 of main plate 8a and is larger in dimension than the plurality of transmission holes 8c. Therefore, by inserting a support rod 51 into first insertion hole 8d1, shield plate 8 can be supported as being suspended from support rod 51. Thus, even though a plurality of shield plates 8 are supported as being suspended from single support rod 51, interference between shield plates 8 can be prevented and deformation of bent portion 8b of each shield plate 8 can be prevented. Therefore, shield plate 8 is readily assembled in housing 4.

(2) In shield plate 8 for a concentrator photovoltaic power generation module according to (1), main plate 8a is provided with a second insertion hole 8d2 that passes through from first surface 8a1 to second surface 8a2, second insertion hole 8d2 being larger in dimension than the plurality of transmission holes 8c.

Support rod 51 can thus be inserted into each of first insertion hole 8d1 and second insertion hole 8d2. Therefore, shield plate 8 can be held by two support rods 51 in a stable manner.

(3) In shield plate 8 for a concentrator photovoltaic power generation module according to (2), main plate 8a has a rectangular outer geometry. First insertion hole 8d1 and second insertion hole 8d2 are aligned along a direction of a long side of rectangular main plate 8a. Each of first insertion hole 8d1 and second insertion hole 8d2 is in a such a shape that a dimension L2 along the direction of the long side (an X direction) of rectangular main plate 8a is larger than a dimension L1 along a direction of a short side (a Y direction) of rectangular main plate 8a.

Support rod 51 is thus readily inserted into first insertion hole 8d1 and second insertion hole 8d2 while first insertion hole 8d1 and second insertion hole 8d2 are inclined with respect to support rod 51. Shield plate 8 is readily inclined with respect to support rod 51 while support rod 51 is located in each of first insertion hole 8d1 and second insertion hole 8d2. Therefore, works for inserting support rods 51 into first insertion hole 8d1 and second insertion hole 8d2 in shield plate 8 are facilitated.

If first insertion hole 8d1 and second insertion hole 8d2 are aligned along the direction of the short side of rectangular main plate 8a, in insertion of support rod 51 in each of first insertion hole 8d1 and second insertion hole 8d2, the direction of the long side of shield plate 8 extends in a vertical direction. Therefore, shield plate 8 tends to be inclined with respect to support rod 51. In contrast, in the example above, first insertion hole 8d1 and second insertion hole 8d2 are aligned along the direction of the long side of rectangular main plate 8a. Therefore, since the direction of the short side of shield plate 8 extends in the vertical direction even while shield plate 8 is supported by support rod 51, shield plate 8 is less likely to be inclined with respect to support rod 51. Therefore, shield plate 8 can be supported by support rod 51 in a stable manner.

(4) In shield plate 8 for a concentrator photovoltaic power generation module according to (2), first insertion hole 8d1 and second insertion hole 8d2 are arranged in line symmetry with respect to a centerline C1 in the direction of the long side (the X direction) of rectangular main plate 8a.

Shield plate 8 can thus be supported by support rod 51 in a balanced manner. Works can be performed regardless of a lateral orientation of shield plate 8.

(5) In shield plate 8 for a concentrator photovoltaic power generation module according to (1), the plurality of transmission holes 8c include four transmission holes 8c arranged at four respective corners of a virtual quadrangle. First insertion hole 8d1 is arranged in a portion where diagonal lines of the virtual quadrangle intersect with each other.

A distance between first insertion hole 8d1 and transmission hole 8c can thus readily been secured. Therefore, even if solar rays are transmitted through first insertion hole 8d1, transmitted light of solar rays is less likely to impinge on an adhesive 2a for bonding a flexible printed circuit board 2 to a bottom plate 1. Therefore, deterioration of adhesive 2a can be suppressed.

(6) In shield plate 8 for a concentrator photovoltaic power generation module according to (1), bent portion 8b includes a burr 8f at a tip end thereof. Bent portion 8b includes a third surface 8b1 continuous to first surface 8a1 and a fourth surface 8b2 continuous to second surface 8a2 and opposed to third surface 8b1. Burr 8f protrudes from third surface 8b1 toward a side opposite to fourth surface 8b2.

Thus, even though shield plate 8 is accommodated in housing 4, burr 8f of shield plate 8 does not impinge on a peripheral wall portion 5 of housing 4. Therefore, chips of housing 4 caused by impingement of burr 8f on peripheral wall portion 5 of housing 4 are not produced and the chips do not interfere with power generation by power generation elements 3 either.

(7) In shield plate 8 for a concentrator photovoltaic power generation module according to (1), main plate 8a is provided with a gripping hole 8e1 that passes through from first surface 8a1 to second surface 8a2, gripping hole 8e1 being larger in dimension than the plurality of transmission holes 8c. Gripping hole 8e1 is arranged on a centerline C2 in a direction of a short side of rectangular main plate 8a. An interval D1 between gripping hole 8e1 and first insertion hole 8d1 is equal to or larger than a pitch P1 between the plurality of transmission holes 8c and smaller than three times as large as pitch P1 between the plurality of transmission holes 8c.

Thus, a worker can carry shield plate 8 with his/her fingers being inserted in gripping hole 8e1 and insertion hole 8d1. When interval D1 between gripping hole 8e1 and insertion hole 8d1 is smaller than pitch P1 between the plurality of transmission holes 8c, it is difficult for the worker to insert his/her fingers into gripping hole 8e1 and insertion hole 8d1. In addition, when support rod 51 is inserted into first insertion hole 8d1, shield plate 8 tends to be inclined with respect to support rod 51. When interval D1 between gripping hole 8e1 and first insertion hole 8d1 is equal to or larger than three times as large as pitch P1 between the plurality of transmission holes 8c, interval D1 between gripping hole 8e1 and first insertion hole 8d1 is too large and it is difficult for the worker to insert his/her fingers into both of gripping hole 8e1 and first insertion hole 8d1.

(8) Concentrator photovoltaic power generation module 10 according to the present disclosure includes shield plate 8 for the concentrator photovoltaic power generation module described in any one of (1) to (7), the plurality of power generation elements 3, a wire of flexible printed circuit board 2, and housing 4. The plurality of power generation elements 3 are provided in correspondence with the plurality of transmission holes 8c, respectively. The wire of flexible printed circuit board 2 is electrically connected to the plurality of power generation elements 3. Shield plate 8 for the concentrator photovoltaic power generation module, the plurality of power generation elements 3, and the wire of flexible printed circuit board 2 are accommodated in housing 4.

According to concentrator photovoltaic power generation module 10 in the present disclosure, shield plate 8 is readily assembled to housing 4 and assembly of concentrator photovoltaic power generation module 10 is facilitated.

(9) In concentrator photovoltaic power generation module 10 according to (8), first insertion hole 8d1 is arranged as being displaced from the wire of flexible printed circuit board 2 in an orthogonal direction (the Y direction) orthogonal to a direction of extension (the X direction) in which the wire extends in a plan view. First insertion hole 8d1 is in such a shape that dimension L2 along the direction of extension (the X direction) is larger than dimension L1 along the orthogonal direction (the Y direction).

Thus, a distance between first insertion hole 8d1 and flexible printed circuit board 2 is readily secured in the plan view. Therefore, even if solar rays are transmitted through first insertion hole 8d1, transmitted light of solar rays is less likely to impinge on adhesive 2a for bonding flexible printed circuit board 2 to bottom plate 1. Therefore, deterioration of adhesive 2a can be suppressed.

(10) A method of manufacturing concentrator photovoltaic power generation module 10 according to the present disclosure is a method of manufacturing concentrator photovoltaic power generation module 10 according to (8) or (9), and the method includes steps below.

By inserting support rod 51 into first insertion hole 8d1 in shield plate 8 for the concentrator photovoltaic power generation module, support rod 51 supports shield plate 8 for the concentrator photovoltaic power generation module. Shield plate 8 for the concentrator photovoltaic power generation module is removed from support rod 51 and arranged in the inside of housing 4.

According to the method of manufacturing concentrator photovoltaic power generation module 10 in the present disclosure, shield plate 8 is readily assembled to housing 4 and assembly of concentrator photovoltaic power generation module 10 is facilitated.

By supporting a plurality of shield plates 8 as being suspended from a single support rod 51, the plurality of shield plates 8 can also be supported within a narrow space.

### [Details of Embodiment of the Present Disclosure]

An embodiment of the present disclosure will be described in detail below with reference to the drawings. The same or corresponding components in the specification and the drawings have the same reference characters allotted and redundant description will not be repeated. In the drawings, a construction may be omitted or simplified for the sake of convenience of description.

### (Construction of Concentrator Photovoltaic Power Generation Apparatus)

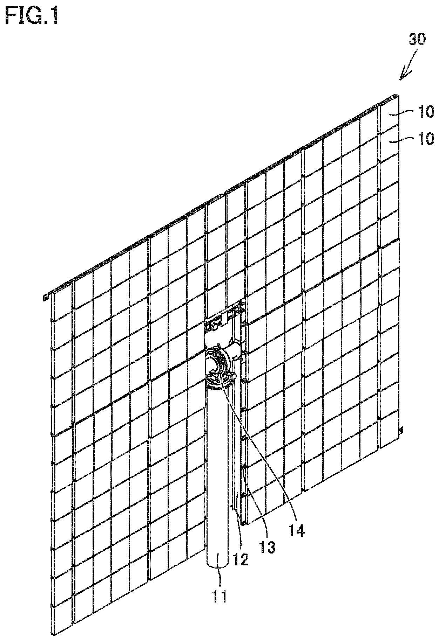

Fig. 1 is a perspective view showing a construction of a concentrator photovoltaic power generation apparatus in one embodiment. As shown in Fig. 1, a concentrator photovoltaic power generation apparatus 30 includes a plurality of concentrator photovoltaic power generation modules 10, a pedestal 11, a plurality of support arms 12, a plurality of rails 13, and a drive apparatus 14.

Pedestal 11 is a portion installed on the ground. Pedestal 11 supports the plurality of support arms 12 and the plurality of rails 13. Each of the plurality of support arms 12 is arranged to extend vertically. Each of the plurality of rails 13 is arranged to extend laterally.

The plurality of concentrator photovoltaic power generation modules 10 are arranged in matrix on the plurality of rails 13.

The plurality of support arms 12 and the plurality of rails 13 are movable with respect to pedestal 11. Specifically, drive apparatus 14 can move the plurality of support arms 12 and the plurality of rails 13 with respect to pedestal 11.

For example, drive apparatus 14 can drive the plurality of support arms 12 and the plurality of rails 13 with respect to pedestal 11 such that concentrator photovoltaic power generation module 10 can operate to follow movement of the sun. Light receiving surfaces of the plurality of concentrator photovoltaic power generation modules 10 can thus face the sun during a period from sunrise to sunset.

For example, drive apparatus 14 can drive the plurality of support arms 12 and the plurality of rails 13 with respect to pedestal 11 such that the light receiving surface of concentrator photovoltaic power generation module 10 faces down. Soil on the light receiving surface can thus be removed (attached sand can be removed), a failed module can be repaired, or maintenance works can be done, with the light receiving surface of concentrator photovoltaic power generation module 10 facing down.

### (Construction of Photovoltaic Power Generation Module)

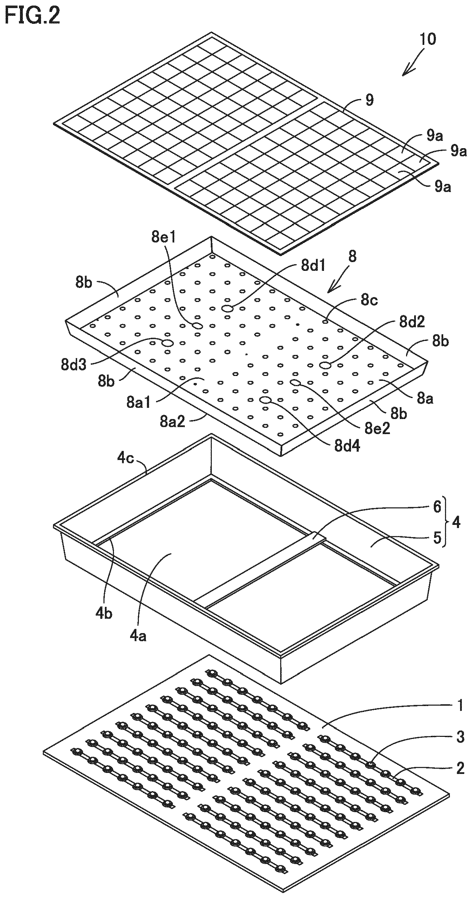

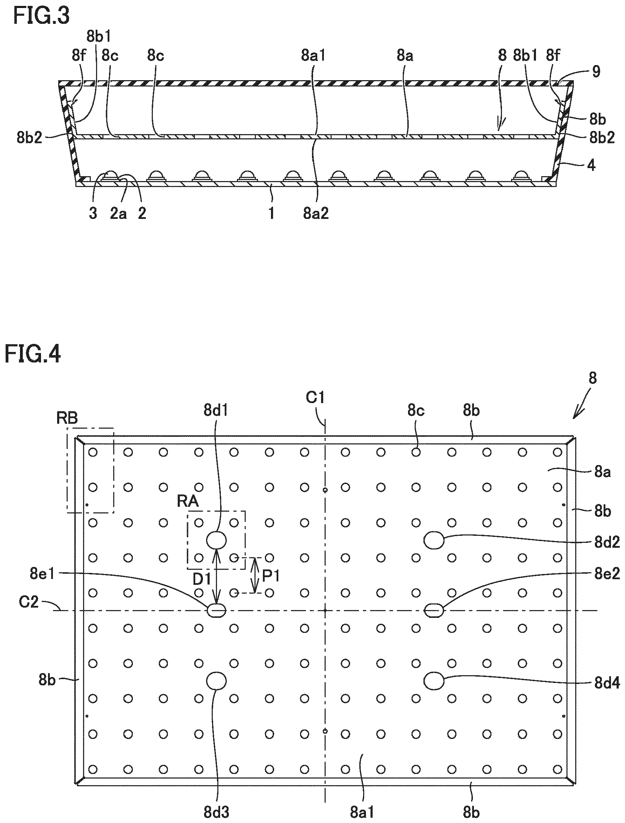

Figs. 2 and 3 are an exploded perspective view and an assembly cross-sectional view showing a construction of the photovoltaic power generation module in one embodiment included in the concentrator photovoltaic power generation apparatus shown in Fig. 1, respectively.

As shown in Figs. 2 and 3, concentrator photovoltaic power generation module 10 mainly includes bottom plate 1, a plurality of flexible printed circuit boards 2, a plurality of power generation elements 3, housing 4, shield plate 8, and a lens member 9.

Housing 4 includes an internal space 4a and a first opening end 4b and a second opening end 4c opposed to each other with internal space 4a lying therebetween. In each of first opening end 4b and second opening end 4c, internal space 4a opens outward.

Housing 4 mainly includes a peripheral wall portion 5 and an intermediate bar 6. Peripheral wall portion 5 is in a frame shape that surrounds internal space 4a. Intermediate bar 6 is attached to first opening end 4b of peripheral wall portion 5. Intermediate bar 6 separates an opening defined by first opening end 4b into two openings.

Bottom plate 1 is made from a flat plate, and composed, for example, of a metal material. Bottom plate 1 is attached to first opening end 4b of housing 4. While bottom plate 1 is attached to housing 4, a surface of bottom plate 1 faces internal space 4a in housing 4.

The plurality of flexible printed circuit boards 2 are bonded to the surface of bottom plate 1 with adhesive 2a (Fig. 3). The plurality of power generation elements 3 are mounted on the plurality of flexible printed circuit boards 2. Each of the plurality of power generation elements 3 is thus attached to bottom plate 1. Each of the plurality of power generation elements 3 is electrically connected to a wire of flexible printed circuit board 2. The plurality of power generation elements 3 are arranged in matrix in a plan view.

Bottom plate 1 is attached to first opening end 4b of housing 4, for example, by welding. Bottom plate 1 closes first opening end 4b of housing 4. While bottom plate 1 is attached to housing 4, the plurality of flexible printed circuit boards 2 and the plurality of power generation elements 3 are located in internal space 4a in housing 4.

Shield plate 8 performs a function to cut off solar rays in a region other than the plurality of power generation elements 3. Shield plate 8 includes a main plate 8a and a bent portion 8b. Main plate 8a includes a first surface 8a1 and a second surface 8a2 opposed to each other. Main plate 8a has, for example, a quadrangular outer geometry. Bent portion 8b is bent to rise from each of four sides of a quadrangular shape of main plate 8a toward first surface 8a1.

Shield plate 8 is constructed by bending a single plate. Shield plate 8 is made, for example, of a metal material. Shield plate 8 is made, for example, of aluminum or an aluminum alloy. Shield plate 8 includes a plurality of transmission holes 8c. Each of the plurality of transmission holes 8c passes through main plate 8a from first surface 8a1 to second surface 8a2. The plurality of transmission holes 8c are arranged in matrix in the plan view. The plurality of transmission holes 8c allow transmission of solar rays toward the plurality of power generation elements 3.

The plan view herein means a point of view in a direction perpendicular to first surface 8a1 of shield plate 8.

Shield plate 8 is arranged in internal space 4a in housing 4 and attached to housing 4, for example, by a screw (not shown). While shield plate 8 is attached to housing 4, the plurality of transmission holes 8c are located directly above the plurality of power generation elements 3, respectively.

Lens member 9 includes a plurality of lens portions 9a. The plurality of lens portions 9a correspond to the plurality of power generation elements 3, respectively. In other words, solar rays concentrated by a single lens portion 9a are emitted to a single power generation element 3. The plurality of lens portions 9a are arranged in matrix in the plan view. Each of the plurality of lens portions 9a is, for example, a Fresnel lens.

Lens member 9 is attached to second opening end 4c of housing 4 by an adhesive. Lens member 9 closes second opening end 4c of housing 4. Solar rays concentrated by each of the plurality of lens portions 9a of lens member 9 are emitted to power generation elements 3 through the plurality of transmission holes 8c. Each power generation element 3 generates electric power in accordance with an amount of light reception upon receiving solar rays concentrated by corresponding lens portion 9a.

### (Construction of Shield Plate)

A construction of shield plate 8 in one embodiment included in concentrator photovoltaic power generation module 10 will now be described with reference to Figs. 3 to 6.

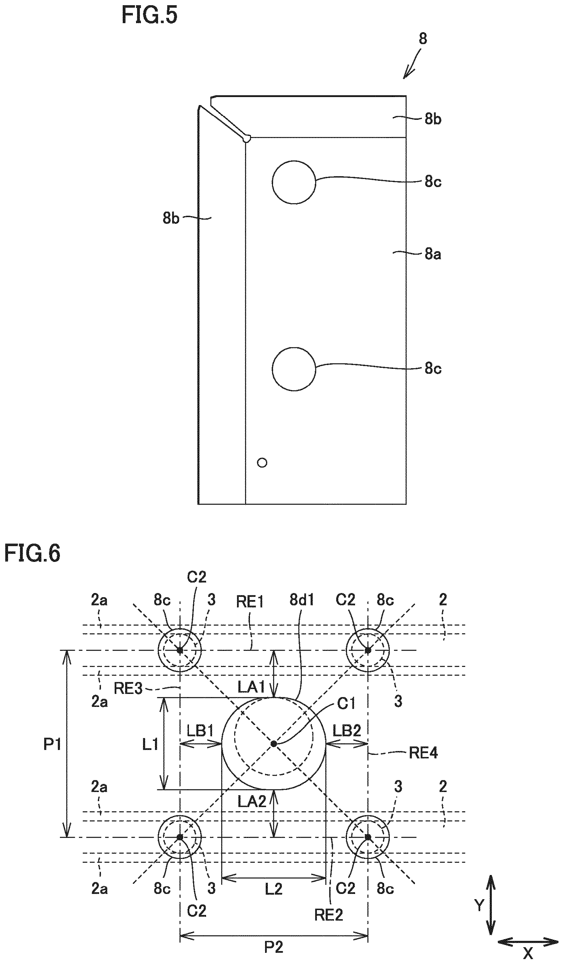

Fig. 4 is a plan view showing a construction of the shield plate for the concentrator photovoltaic power generation module in one embodiment included in the concentrator photovoltaic power generation module shown in Fig. 2. Figs. 5 and 6 are partially enlarged plan views of a region RB and a region RA in Fig. 4, respectively.

As shown in Fig. 4, main plate 8a has, for example, a rectangular outer geometry (two-dimensional shape). Bent portion 8b is bent to rise from each of four sides of rectangular main plate 8a toward first surface 8a1.

Main plate 8a is provided with a plurality of transmission holes 8c as described above. The plurality of transmission holes 8c each pass through main plate 8a from first surface 8a1 to second surface 8a2 and allow transmission of solar rays toward the plurality of power generation elements 3.

Main plate 8a is provided with a plurality of (for example, four) insertion holes 8d1, 8d2, 8d3, and 8d4. Each of insertion holes 8d1, 8d2, 8d3, and 8d4 passes through main plate 8a from first surface 8a1 to second surface 8a2. Each of insertion holes 8d1, 8d2, 8d3, and 8d4 is larger in dimension (two-dimensional shape) than the plurality of transmission holes 8c. In other words, each of insertion holes 8d1, 8d2, 8d3, and 8d4 is larger in two-dimensionally occupied area than the plurality of transmission holes 8c.

Insertion hole 8d1 (the first insertion hole) and insertion hole 8d2 (the second insertion hole) are aligned along the direction of the long side of rectangular main plate 8a. Insertion hole 8d3 (the third insertion hole) and insertion hole 8d4 (the fourth insertion hole) are aligned along the direction of the long side of rectangular main plate 8a.

Insertion hole 8d1 and insertion hole 8d3 are aligned along the direction of the short side of rectangular main plate 8a. Insertion hole 8d2 and insertion hole 8d4 are aligned along the direction of the short side of rectangular main plate 8a.

An interval between insertion hole 8d1 and insertion hole 8d2 is equal to an interval between insertion hole 8d3 and insertion hole 8d4. An interval between insertion hole 8d1 and insertion hole 8d3 is equal to an interval between insertion hole 8d2 and insertion hole 8d4.

Insertion hole 8d1 and insertion hole 8d2 are arranged in line symmetry with respect to centerline C1 in the direction of the long side (the X direction) of rectangular main plate 8a. Insertion hole 8d3 and insertion hole 8d4 are arranged in line symmetry with respect to centerline C1 in the direction of the long side (the X direction) of rectangular main plate 8a.

Insertion hole 8d1 and insertion hole 8d3 are arranged in line symmetry with respect to centerline C2 in the direction of the short side (the Y direction) of rectangular main plate 8a. Insertion hole 8d2 and insertion hole 8d4 are arranged in line symmetry with respect to centerline C2 in the direction of the short side (the Y direction) of rectangular main plate 8a.

Main plate 8a is provided with a plurality of (for example, two) holes for holding 8e1 and 8e2. Each of holes for holding 8e1 and 8e2 passes through main plate 8a from first surface 8a1 to second surface 8a2. Each of holes for holding 8e1 and 8e2 is larger in dimension (two-dimension shape) than the plurality of transmission holes 8c. In other words, each of holes for holding 8e1 and 8e2 is larger in two-dimensionally occupied area than the plurality of transmission holes 8c.

Gripping hole 8e1 is located between insertion hole 8d1 and insertion hole 8d3. Gripping hole 8e1 and insertion holes 8d1 and 8d3 are aligned along the direction of the short side of rectangular main plate 8a.

Gripping hole 8e2 is located between insertion hole 8d2 and insertion hole 8d4. Gripping hole 8e2 and insertion holes 8d2 and 8d4 are aligned along the direction of the short side of rectangular main plate 8a.

Each of holes for holding 8e1 and 8e2 is arranged on centerline C2 in the direction of the short side of rectangular main plate 8a. Gripping hole 8e1 and gripping hole 8e2 are aligned along the direction of the long side of rectangular main plate 8a.

Interval D1 between gripping hole 8e1 and insertion hole 8d1 is equal to or larger than pitch P1 between the plurality of transmission holes 8c and smaller than three times as large as pitch P1 between the plurality of transmission holes 8c. An interval between gripping hole 8e1 and insertion hole 8d3, an interval between gripping hole 8e2 and insertion hole 8d2, and an interval between gripping hole 8e2 and insertion hole 8d4 are also equal to or larger than pitch P1 between the plurality of transmission holes 8c and smaller than three times as large as pitch P1 between the plurality of transmission holes 8c.

The interval between gripping hole 8e1 and insertion hole 8d1 is equal to each of the interval between gripping hole 8e1 and insertion hole 8d3, the interval between gripping hole 8e2 and insertion hole 8d2, and the interval between gripping hole 8e2 and insertion hole 8d4.

Shield plate 8 has an outer dimension in the direction of the long side, for example, not smaller than 400 mm and not larger than 1000 mm. Shield plate 8 has an outer dimension in the direction of the short side, for example, not smaller than 300 mm and not larger than 900 mm. A plate that forms shield plate 8 has a thickness, for example, not smaller than 0.2 mm and not larger than 0.5 mm. The plate that forms shield plate 8 has a thickness, for example, of 0.3 mm.

As shown in Fig. 5, a slit is provided between bent portions 8b bent from sides of main plate 8a joined to each other. Thus, bent portions 8b adjacent to each other are not connected to each other but separate from each other. Specifically, bent portion 8b bent from the long side of rectangular main plate 8a is not connected to but separate from bent portion 8b bent from the short side of rectangular main plate 8a.

As shown in Fig. 6, insertion hole 8d1 is, for example, oval. Specifically, insertion hole 8d1 is in such a shape that dimension L2 along the direction of the long side (the X direction) of rectangular main plate 8a is larger than dimension L1 along the direction of the short side (the Y direction) of rectangular main plate 8a. Each of insertion holes 8d2, 8d3, and 8d4 is identical in shape to insertion hole 8d1.

Four transmission holes 8c are arranged around insertion hole 8d1. Four transmission holes 8c are arranged at four respective corners of a virtual quadrangle (for example, a square). Insertion hole 8d1 is arranged in a portion where diagonal lines of the virtual quadrangle intersect with each other. Similarly to insertion hole 8d1, each of insertion holes 8d2, 8d3, and 8d4 is arranged in a portion where diagonal lines of the virtual quadrangle where four transmission holes 8c are arranged intersect with each other.

An interval LA1 between a first side RE1 of the virtual quadrangle and insertion hole 8d1 is equal to an interval LA2 between a second side RE2 which is a side opposite to first side RE1 and insertion hole 8d1. An interval LB1 between a third side RE3 of the virtual quadrangle and insertion hole 8d1 is equal to an interval LB2 between a fourth side RE4 which is a side opposite to third side RE3 and insertion hole 8d1. Intervals LA1 and LA2 are larger than intervals LB1 and LB2.

Insertion hole 8d1 is arranged as being displaced from the wire of flexible printed circuit board 2 in the orthogonal direction (the Y direction) orthogonal to the direction of extension (the X direction) in which the wire extends in the plan view. Insertion hole 8d1 is in such a shape that dimension L2 along the direction of extension (the X direction) is larger than dimension L1 along the orthogonal direction (the Y direction).

Insertion hole 8d1 has dimension L1, for example, not smaller than 20 mm and not larger than 35 mm and dimension L2, for example, not smaller than 24 mm and not larger than 40 mm. Pitch P1 between transmission holes 8c is, for example, not smaller than 50 mm and not larger than 80 mm.

A pitch P2 between transmission holes 8c in the direction of extension (the X direction) is equal to pitch P1 between transmission holes 8c in the orthogonal direction (the Y direction). Pitch P2 may be different from pitch P1.

As shown in Fig. 3, bent portion 8b includes third surface 8b1 continuous to first surface 8a1 and fourth surface 8b2 continuous to second surface 8a2 and opposed to third surface 8b1. Bent portion 8 includes burr 8f at the tip end thereof. Burr 8f protrudes from third surface 8b1 toward a side opposite to fourth surface 8b2. There is no burr 8f in fourth surface 8b2. Fourth surface 8b2 of bent portion 8b is a rear surface of third surface 8b1.

### (Method of Manufacturing Photovoltaic Power Generation Module)

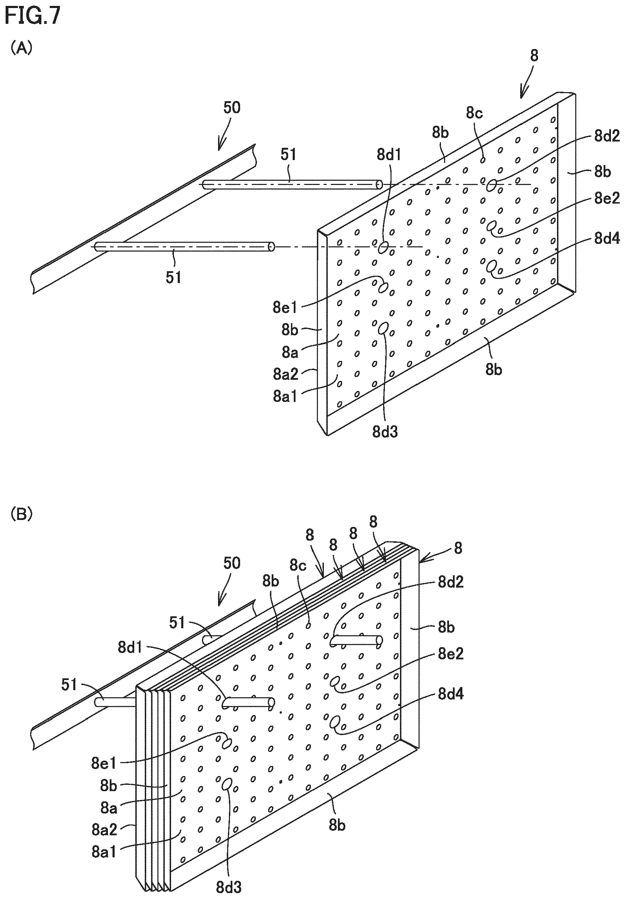

A method of manufacturing a photovoltaic power generation module according to the present embodiment will now be described with reference to Figs. 7 to 9.

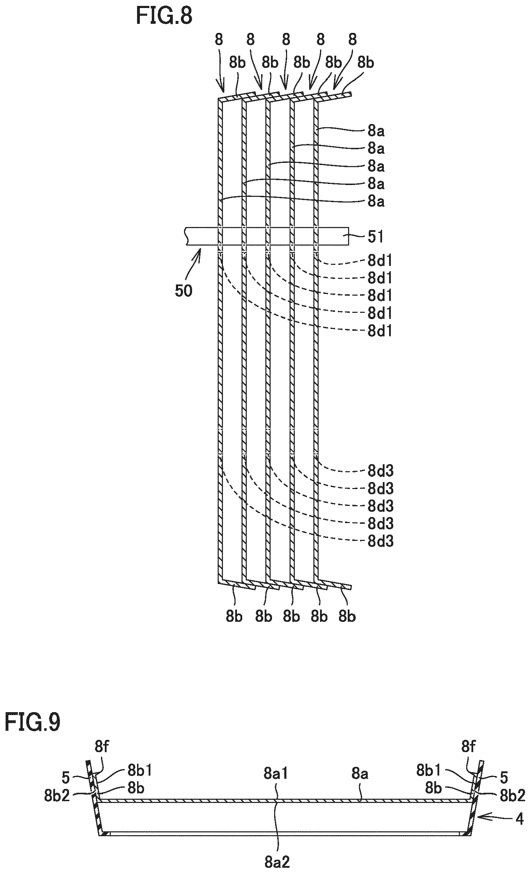

Figs. 7 and 8 are a perspective view and a side view showing a first step in the method of manufacturing the concentrator photovoltaic power generation module in one embodiment, respectively. Fig. 9 is a cross-sectional view showing a second step in the method of manufacturing the concentrator photovoltaic power generation module in one embodiment.

The plurality of transmission holes 8c, the plurality of insertion holes 8d1 to 8d4, and the plurality of holes for holding 8e1 and 8e2 are initially provided in a single plate. Thereafter, the plate is bent to form shield plate 8 including main plate 8a and bent portion 8b as shown in Fig. 4.

As shown in Fig. 7 (A) and (B), shield plate 8 is held by a jig 50 including two support rods 51 by inserting support rod 51 in each of insertion holes 8d1 and 8d2.

As shown in Fig. 8, while a plurality of shield plates 8 are supported by support rods 51, the weight of each of the plurality of shield plates 8 is applied to support rods 51 and is not applied to other shield plates 8. Therefore, deformation of shield plate 8 due to pressing by shield plates 8 against each other can be prevented.

While the plurality of shield plates 8 shown in Fig. 8 are held by jig 50, jig 50 is transported to a site of assembly to housing 4 and the like.

As shown in Fig. 9, at the assembly site, shield plate 8 is removed from support rod 51 and arranged in the inside of housing 4. Thereafter, shield plate 8 is fixed to housing 4 by a screw or the like.

Thereafter, bottom plate 1 on which the plurality of power generation elements 3 are mounted and lens member 9 are attached to shield plate 8 as shown in Fig. 3 to thereby manufacture concentrator photovoltaic power generation module 10 in the present embodiment.

Bottom plate 1 on which the plurality of power generation elements 3 are mounted may be attached to housing 4 before shield plate 8 is attached to housing 4.

### (Effects of the Present Embodiment)

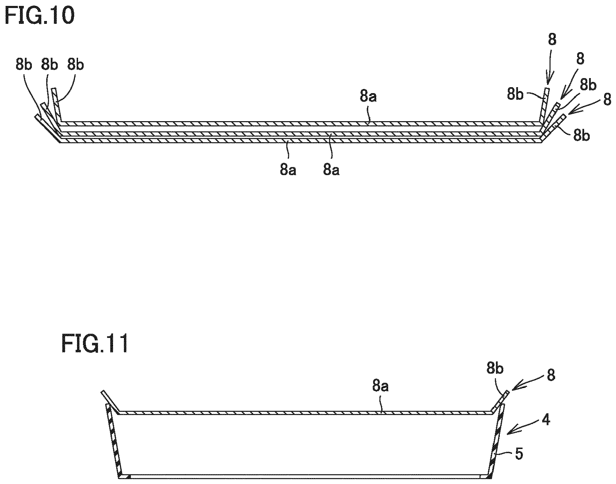

Functions and effects of the present embodiment will now be described in comparison with a comparative example shown in Figs. 10 and 11.

According to the present embodiment, as shown in Figs. 3 and 4, shield plate 8 includes bent portion 8b. Bent portion 8b is bent to rise from each of four sides of the quadrangular shape of main plate 8a toward first surface 8a1. By providing bent portion 8b, shield plate 8 according to the present disclosure can be higher in strength than the shield plate formed only from main plate 8a. Thus, even though shield plate 8 is made smaller in thickness and larger in size, shield plate 8 is less likely to warp. Therefore, shield plate 8 is readily assembled in housing 4.

As in the comparative example shown in Fig. 10, shield plates 8 provided with bent portion 8b may vertically be layered during transportation. In this case, lower shield plate 8 is pressed by upper shield plate 8 due to its weight. Bent portion 8b of lower shield plate 8 is thus pressed downward by upper shield plate 8 and deforms to spread.

As shown in Fig. 11, in arranging shield plate 8 in the inside of housing 4, bent portion 8b has spread and hence it is difficult to arrange shield plate 8 in the inside of housing 4. When shield plate 8 is forcibly pressed into housing 4 from this state, bent portion 8b may shave peripheral wall portion 5 of housing 4. When peripheral wall portion 5 is shaved, chips are produced and may adhere onto power generation elements 3. Then, efficiency in power generation by power generation elements 3 may be lowered.

Even though shield plate 8 could be arranged in housing 4, shield plate 8 may not be arranged at a prescribed height position within housing 4. In this case, light transmitted to power generation elements 3 is less and power generation efficiency may be lowered.

In contrast, in the present embodiment, shield plate 8 includes insertion hole 8d1 as shown in Fig. 4. Insertion hole 8d1 passes through from first surface 8a1 of main plate 8a to second surface 8a2 and it is larger in dimension than the plurality of transmission holes 8c. Therefore, as shown in Fig. 7 (A) and (B), by inserting support rod 51 into insertion hole 8d1, shield plate 8 can be supported as being suspended from support rod 51. Thus, even though a plurality of shield plates 8 are supported as being suspended from a single support rod 51, shield plates 8 can be prevented from interfering with each other as shown in Fig. 8. Therefore, deformation of bent portion 8b of each shield plate 8 can be prevented. Accordingly, assembly of shield plate 8 within housing 4 is facilitated and lowering in power generation efficiency does not occur either.

In the present embodiment, as shown in Fig. 4, main plate 8a is provided with insertion hole 8d2 that passes through from first surface 8a1 to second surface 8a2 and is larger in dimension than the plurality of transmission holes 8c. Thus, as shown in Fig. 7 (B), support rod 51 can be inserted in each of insertion hole 8d1 and insertion hole 8d2. Therefore, shield plate 8 can be held by two support rods 51 in a stable manner.

In the present embodiment, as shown in Fig. 4, main plate 8a has a rectangular outer geometry. Insertion hole 8d1 and insertion hole 8d2 are aligned along the direction of the long side of rectangular main plate 8a. Each of insertion holes 8d1 and 8d2 is in such a shape that dimension L2 along the direction of the long side (the X direction) of rectangular main plate 8a is larger than dimension L1 along the direction of the short side (the Y direction) of rectangular main plate 8a. Support rod 51 is thus readily inserted into each of insertion holes 8d1 and 8d2 while each of insertion holes 8d1 and 8d2 is inclined with respect to support rod 51. Shield plate 8 is also readily inclined with respect to support rod 51 while support rod 51 is located in each of insertion holes 8d1 and 8d2. Therefore, works for inserting support rods 51 into insertion holes 8d1 and 8d2 are facilitated.

Insertion hole 8d1 and insertion hole 8d2 are aligned along the direction of the long side of rectangular main plate 8a. Therefore, the direction of the short side of main plate 8a extends in the vertical direction while shield plate 8 is supported by support rod 51. Accordingly, shield plate 8 is less likely to be inclined with respect to support rod 51 than in an example where the direction of the long side of main plate 8a extends in the vertical direction. Therefore, shield plate 8 can be supported by support rod 51 in a stable manner.

In the present embodiment, as shown in Fig. 4, insertion hole 8d1 and insertion hole 8d2 are arranged in line symmetry with respect to centerline C1 in the direction of the long side (the X direction) of rectangular main plate 8a. Shield plate 8 can thus be supported by support rod 51 in a balanced manner. Works can be performed regardless of a lateral orientation of shield plate 8.

In the present embodiment, as shown in Fig. 6, the plurality of transmission holes 8c include four transmission holes 8c arranged at four respective corners of a virtual quadrangle. Insertion hole 8d1 is arranged in a portion where diagonal lines of the virtual quadrangle intersect with each other. A distance between insertion hole 8d1 and transmission hole 8c is thus readily secured. Therefore, even though solar rays are transmitted through insertion hole 8d1, transmitted light of solar rays is less likely to impinge on adhesive 2a for bonding flexible printed circuit board 2 to bottom plate 1. Therefore, deterioration of adhesive 2a can be suppressed.

In the present embodiment, as shown in Fig. 3, bent portion 8b includes burr 8f at the tip end thereof. Burr 8f is provided to protrude from third surface 8b1 of bent portion 8b continuous to first surface 8a1. Thus, even though shield plate 8 is accommodated in housing 4, burr 8f of shield plate 8 does not impinge on peripheral wall portion 5 of housing 4. Therefore, chips of housing 4 produced by impingement of burr 8f on peripheral wall portion 5 of housing 4 are not produced and the chips do not interfere with power generation by power generation elements 3 either.

In the present embodiment, as shown in Fig. 4, main plate 8a is provided with gripping hole 8e1 that passes through from first surface 8a1 to second surface 8a2 and is larger in dimension than the plurality of transmission holes 8c. Gripping hole 8e1 is arranged on centerline C2 in the direction of the short side of rectangular main plate 8a. Interval D1 between gripping hole 8e1 and insertion hole 8d1 is equal to or larger than pitch P1 between the plurality of transmission holes 8c and smaller than three times as large as pitch P1 between the plurality of transmission holes 8c. A worker can thus carry shield plate 8 by inserting his/her fingers into gripping hole 8e1 and insertion hole 8d1.

When interval D1 between gripping hole 8e1 and insertion hole 8d1 is smaller than pitch P1 between the plurality of transmission holes 8c, it is difficult for the worker to insert his/her fingers into gripping hole 8e1 and insertion hole 8d1 and shield plate 8 tends to be inclined with respect to support rod 51 in insertion of support rod 51 into insertion hole 8d1. When interval D1 between gripping hole 8e1 and insertion hole 8d1 is equal to or larger than three times as large as pitch P1 between the plurality of transmission holes 8c, interval D1 between gripping hole 8e1 and insertion hole 8d1 is too large and it is difficult for the worker to insert his/her fingers into both of gripping hole 8e1 and insertion hole 8d1.

In the present embodiment, as shown in Fig. 4, insertion hole 8d1 is arranged as being displaced from the wire of flexible printed circuit board 2 in the orthogonal direction (the Y direction) orthogonal to the direction of extension (the X direction) in which the wire extends in the plan view. Insertion hole 8d1 is in a such a shape that dimension L2 along the direction of extension (the X direction) is larger than dimension L1 along the orthogonal direction (the Y direction). A distance between insertion hole 8d1 and flexible printed circuit board 2 in the plan view is thus readily secured. Therefore, even though solar rays are transmitted through insertion hole 8d1, transmitted light of solar rays is less likely to impinge on adhesive 2a for bonding flexible printed circuit board 2 to bottom plate 1. Therefore, deterioration of adhesive 2a can be suppressed.

In the present embodiment, as shown in Fig. 8, by inserting support rod 51 into insertion hole 8d1 in shield plate 8 for the concentrator photovoltaic power generation module, support rod 51 supports shield plate 8 for the concentrator photovoltaic power generation module. By thus supporting a plurality of shield plates 8 as being suspended from single support rod 51, the plurality of shield plates 8 can also be supported within a narrow space.

It should be understood that the embodiment disclosed herein is illustrative and non-restrictive in every respect. The scope of the present invention is defined by the terms of the claims.

### REFERENCE SIGNS LIST

1 bottom plate; 2 flexible printed circuit board; 2a adhesive; 3 power generation element; 4 housing; 4a internal space; 4b first opening end; 4c second opening end; 5 peripheral wall portion; 6 intermediate bar; 8 shield plate; 8a main plate; 8a1 first surface; 8a2 second surface; 8b2, 8b1 surface; 8b bent portion; 8c transmission hole; 8d1, 8d2, 8d3, 8d4 insertion hole; 8e1, 8e2 gripping hole; 8f burr; 9 lens member; 9a lens portion; 10 concentrator photovoltaic power generation module; 11 pedestal; 12 support arm; 13 rail; 14 drive apparatus; 30 concentrator photovoltaic power generation apparatus; 50 jig; 51 support rod; C1, C2 centerline; RA, RB region; RE1 first side; RE2 second side; RE3 third side; RE4 fourth side

## Claims

1. A shield plate (8) for a concentrator photovoltaic power generation module (10) that cuts off solar rays in a region other than a plurality of power generation elements (3) included in the concentrator photovoltaic power generation module, the shield plate comprising:
a main plate (8a) including a first surface (8a1) and a second surface (8a2) opposed to each other, the main plate having a quadrangular shape; and
a bent portion (8b) bent to rise from each of four sides of the quadrangular shape of the main plate toward the first surface,
the main plate being provided with a plurality of transmission holes (8c) that pass through from the first surface to the second surface, solar rays being transmitted through the plurality of transmission holes toward the plurality of power generation elements,
**characterized in that** the main plate is provided with a first insertion hole (8d1) that passes through from the first surface to the second surface, the first insertion hole being larger in dimension than the plurality of transmission holes.

2. The shield plate for a concentrator photovoltaic power generation module according to claim 1, wherein
the main plate is provided with a second insertion hole (8d2) that passes through from the first surface to the second surface, the second insertion hole being larger in dimension than the plurality of transmission holes.

3. The shield plate for a concentrator photovoltaic power generation module according to claim 2, wherein
the main plate has a rectangular outer geometry,
the first insertion hole and the second insertion hole are aligned along a direction of a long side of the main plate in a rectangular shape, and
each of the first insertion hole and the second insertion hole is in a such a shape that a dimension along the direction of the long side of the main plate in the rectangular shape is larger than a dimension along a direction of a short side of the main plate in the rectangular shape.

4. The shield plate for a concentrator photovoltaic power generation module according to claim 2, wherein
the first insertion hole and the second insertion hole are arranged in line symmetry with respect to a centerline in the direction of the long side of the main plate in a rectangular shape.

5. The shield plate for a concentrator photovoltaic power generation module according to claim 1, wherein
the plurality of transmission holes include four transmission holes arranged at four respective corners of a virtual quadrangle, and
the first insertion hole is arranged in a portion where diagonal lines of the virtual quadrangle intersect with each other.

6. The shield plate for a concentrator photovoltaic power generation module according to claim 1, wherein
the bent portion includes a burr at a tip end,
the bent portion includes a third surface continuous to the first surface and a fourth surface continuous to the second surface and opposed to the third surface, and
the burr protrudes from the third surface toward a side opposite to the fourth surface.

7. The shield plate for a concentrator photovoltaic power generation module according to claim 1, wherein
the main plate is provided with a gripping hole (8e1) that passes through from the first surface to the second surface, the gripping hole being larger in dimension than the plurality of transmission holes,
the gripping hole is arranged on a centerline in a direction of a short side of the main plate in a rectangular shape, and
an interval between the gripping hole and the first insertion hole is equal to or larger than a pitch between the plurality of transmission holes and smaller than three times as large as the pitch between the plurality of transmission holes.

8. A concentrator photovoltaic power generation module comprising:
the shield plate for the concentrator photovoltaic power generation module according to claim 1;
the plurality of power generation elements provided in correspondence with the plurality of transmission holes, respectively;
a wire electrically connected to the plurality of power generation elements; and
a housing in which the shield plate for the concentrator photovoltaic power generation module, the plurality of power generation elements, and the wire are accommodated.

9. The concentrator photovoltaic power generation module according to claim 8, wherein
the first insertion hole is arranged as being displaced from the wire in an orthogonal direction orthogonal to a direction of extension in which the wire extends in a plan view, and
the first insertion hole is in such a shape that a dimension along the direction of extension is larger than a dimension along the orthogonal direction.

10. A method of manufacturing the concentrator photovoltaic power generation module according to claim 8, the method comprising:
supporting the shield plate for the concentrator photovoltaic power generation module with a support rod by inserting the support rod into the first insertion hole in the shield plate for the concentrator photovoltaic power generation module; and
removing the shield plate for the concentrator photovoltaic power generation module from the support rod and arranging the shield plate in inside of the housing.

## Patentansprüche

1. Abschirmungsplatte (8) für ein Konzentrator-Photovoltaik-Stromerzeugungsmodul (10), die Sonnenstrahlen in einem anderen Bereich als einer Mehrzahl von in dem Konzentrator-Photovoltaik-Stromerzeugungsmodul vorgesehenen Stromerzeugungselementen (3) abschirmt, wobei die Abschirmungsplatte umfasst:
eine Hauptplatte (8a) mit einer ersten Oberfläche (8a1) und einer zweiten Oberfläche (8a2), die einander gegenüberliegen, wobei die Hauptplatte eine viereckige Form aufweist; und
einen gebogenen Abschnitt (8b), der so gebogen ist, dass er von jeder der vier Seiten der viereckigen Form der Hauptplatte in Richtung der ersten Oberfläche aufragt, wobei die Hauptplatte mit einer Mehrzahl von Durchgangslöchern (8c) versehen ist, die von der ersten Oberfläche zu der zweiten Oberfläche durchgehen, wobei Sonnenstrahlen durch die Mehrzahl von Durchgangslöchern in Richtung der Mehrzahl von Stromerzeugungselementen durchgelassen werden, **dadurch gekennzeichnet, dass** die Hauptplatte mit einem ersten Einsetzloch (8d1) versehen ist, das von der ersten Oberfläche zu der zweiten Oberfläche durchgeht, wobei das erste Einsetzloch größer bemessen ist als die Mehrzahl der Durchgangslöcher.

2. Abschirmungsplatte für ein Konzentrator-Photovoltaik-Stromerzeugungsmodul nach Anspruch 1, wobei
die Hauptplatte mit einem zweiten Einsetzloch (8d2) versehen ist, das von der ersten Oberfläche zur zweiten Oberfläche durchgeht, wobei das zweite Einsetzloch größer bemessen ist als die Mehrzahl der Durchgangslöcher.

3. Abschirmungsplatte für ein Konzentrator-Photovoltaik-Stromerzeugungsmodul nach Anspruch 2, wobei
die Hauptplatte eine rechteckige Außengeometrie aufweist, das erste Einsetzloch und das zweite Einsetzloch entlang einer Richtung einer langen Seite der Hauptplatte in einer rechteckigen Form ausgerichtet sind, und
das erste Einsetzloch und das zweite Einsetzloch jeweils eine solche Form aufweisen, dass eine Abmessung entlang der Richtung der langen Seite der Hauptplatte in der rechteckigen Form größer ist als eine Abmessung entlang einer Richtung einer kurzen Seite der Hauptplatte in der rechteckigen Form.

4. Abschirmungsplatte für ein Konzentrator-Photovoltaik-Stromerzeugungsmodul nach Anspruch 2, wobei
das erste Einsetzloch und das zweite Einsetzloch achsensymmetrisch in Bezug auf eine Mittellinie in Richtung der langen Seite der Hauptplatte in einer rechteckigen Form angeordnet sind.

5. Abschirmungsplatte für ein Konzentrator-Photovoltaik-Stromerzeugungsmodul nach Anspruch 1, wobei
die Mehrzahl von Durchgangslöchern vier Durchgangslöcher umfasst, die an vier jeweiligen Ecken eines virtuellen Vierecks angeordnet sind, und
das erste Einsetzloch in einem Abschnitt angeordnet ist, in dem sich diagonale Linien des virtuellen Vierecks gegenseitig schneiden.

6. Abschirmungsplatte für ein Konzentrator-Photovoltaik-Stromerzeugungsmodul nach Anspruch 1, wobei
der gebogene Abschnitt einen Grat an einem Spitzenende aufweist,
der gebogene Abschnitt eine dritte Fläche, die sich an die erste Fläche anschließt, und eine vierte Fläche aufweist, die sich an die zweite Fläche anschließt und der dritten Fläche gegenüberliegt, und
der Grat von der dritten Fläche in Richtung einer der vierten Fläche gegenüberliegenden Seite hervorragt.

7. Abschirmungsplatte für ein Konzentrator-Photovoltaik-Stromerzeugungsmodul nach Anspruch 1, wobei
die Hauptplatte mit einem Griffloch (8e1) versehen ist, das von der ersten Oberfläche zur zweiten Oberfläche durchgeht, wobei das Griffloch größer bemessen ist als die Mehrzahl der Durchgangslöcher,
das Griffloch auf einer Mittellinie in Richtung einer kurzen Seite der Hauptplatte in einer rechteckigen Form angeordnet ist, und
ein Abstand zwischen dem Griffloch und dem ersten Einsetzloch gleich oder größer als ein Teilungsabstand zwischen der Mehrzahl von Durchgangslöchern und kleiner als dreimal der Teilungsabstand zwischen der Mehrzahl von Durchgangslöchern ist.

8. Konzentrator-Photovoltaik-Stromerzeugungsmodul, umfassend:
die Abschirmungsplatte für das Konzentrator-Photovoltaik-Stromerzeugungsmodul nach Anspruch 1;
die Mehrzahl von Stromerzeugungselementen, die jeweils entsprechend der Mehrzahl von Durchgangslöchern vorgesehen sind;
einen Draht, der elektrisch mit der Mehrzahl der Stromerzeugungselemente verbunden ist; und
ein Gehäuse, in dem die Abschirmungsplatte für das Konzentrator-Photovoltaik-Stromerzeugungsmodul, die Mehrzahl der Stromerzeugungselemente und der Draht untergebracht sind.

9. Konzentrator-Photovoltaik-Stromerzeugungsmodul nach Anspruch 8, wobei
das erste Einsetzloch so angeordnet ist, dass es von dem Draht in einer orthogonalen Richtung orthogonal zu einer Erstreckungsrichtung versetzt ist, in der sich der Draht in einer Draufsicht erstreckt, und
das erste Einsetzloch eine solche Form aufweist, dass eine Abmessung entlang der Erstreckungsrichtung größer ist als eine Abmessung entlang der orthogonalen Richtung.

10. Verfahren zur Herstellung des Konzentrator-Photovoltaik-Stromerzeugungsmodul nach Anspruch 8, umfassend:
Stützen der Abschirmungsplatte für das Konzentrator-Photovoltaik-Stromerzeugungsmodul mit einer Stützstange durch Einsetzen der Stützstange in das erste Einsetzloch in der Abschirmungsplatte für das Konzentrator-Photovoltaik-Stromerzeugungsmodul; und
Entfernen der Abschirmungsplatte für das Konzentrator-Photovoltaik-Stromerzeugungsmodul von der Stützstange und Anordnen der Abschirmungsplatte im Inneren des Gehäuses.

## Revendications

1. Plaque de blindage (8) pour un module de génération d'énergie photovoltaïque (10) à concentrateur qui coupe les rayons du soleil dans une région, différent d'une pluralité d'éléments de génération d'énergie (3) inclus dans le module de génération d'énergie photovoltaïque à concentrateur, la plaque de blindage comprenant :
une plaque principale (8a) comprenant une première surface (8a1) et une deuxième surface (8a2) opposées l'une à l'autre,
la plaque principale ayant une forme quadrangulaire ; et
une partie courbée (8b) courbée pour se lever à partir de chacun des quatre côtés de la forme quadrangulaire de la plaque principale vers la première surface,
la plaque principale étant prévue avec une pluralité de trous de transmission (8c) qui traversent de la première surface à la deuxième surface, les rayons du soleil étant transmis par la pluralité de trous de transmission vers la pluralité d'éléments de génération d'énergie,
**caractérisée en ce que** la plaque principale est prévue avec un premier trou d'insertion (8d1) qui traverse de la première surface à la deuxième surface, le premier trou d'insertion étant plus grand, du point de vue de la dimension, que la pluralité de trous de transmission.

2. Plaque de blindage pour un module de génération d'énergie photovoltaïque à concentrateur selon la revendication 1, dans laquelle :
la plaque principale est prévue avec un second trou d'insertion (8d2) qui traverse de la première surface à la deuxième surface, le second trou d'insertion étant plus grand, du point de vue de la dimension, que la pluralité de trous de transmission.

3. Plaque de blindage pour un module de génération d'énergie photovoltaïque à concentrateur selon la revendication 2, dans laquelle :
la plaque principale a une géométrie externe rectangulaire,
le premier trou d'insertion et le second trou d'insertion sont alignés le long d'une direction d'un côté long de la plaque principale dans une forme rectangulaire, et
chacun parmi le premier trou d'insertion et le second trou d'insertion a une forme telle qu'une dimension le long de la direction du côté long de la plaque principale dans la forme rectangulaire est supérieure à une dimension le long d'une direction d'un côté court de la plaque principale dans la forme rectangulaire.

4. Plaque de blindage pour un module de génération d'énergie photovoltaïque à concentrateur selon la revendication 2, dans laquelle :
le premier trou d'insertion et le second trou d'insertion sont agencés en symétrie axiale par rapport à une ligne centrale dans la direction du côté long de la plaque principale dans une forme rectangulaire.

5. Plaque de blindage pour un module de génération d'énergie photovoltaïque à concentrateur selon la revendication 1, dans laquelle :
la pluralité de trous de transmission comprend quatre trous de transmission agencés aux quatre coins respectifs d'un quadrilatère virtuel, et
le premier trou d'insertion est agencé dans une partie où les lignes diagonales du quadrilatère virtuel se coupent.

6. Plaque de blindage pour un module de génération d'énergie photovoltaïque à concentrateur selon la revendication 1, dans laquelle :
la partie courbée comprend une bavure au niveau d'une extrémité de pointe,
la partie courbée comprend une troisième surface continue par rapport à la première surface et une quatrième surface continue par rapport à la deuxième surface et opposée à la troisième surface, et
la bavure fait saillie de la troisième surface vers un côté opposé à la quatrième surface.

7. Plaque de blindage pour un module de génération d'énergie photovoltaïque à concentrateur selon la revendication 1, dans laquelle :
la plaque principale est prévue avec un trou de préhension (8e1) qui traverse de la première surface à la deuxième surface, le trou de préhension étant plus grand, du point de vue de la dimension, que la pluralité de trous de transmission,
le trou de préhension est agencé sur une ligne centrale dans une direction d'un côté court de la plaque principale dans une forme rectangulaire, et
un intervalle entre le trou de préhension et le premier trou d'insertion est égal ou supérieur à un pas entre la pluralité de trous de transmission et inférieur à trois fois plus grand que le pas entre la pluralité de trous de transmission.

8. Plaque de blindage pour un module de génération d'énergie photovoltaïque à concentrateur comprenant :
la plaque de blindage pour le module de génération d'énergie photovoltaïque à concentrateur selon la revendication 1 ;
la pluralité d'éléments de génération d'énergie respectivement prévue en correspondance avec la pluralité de trous de transmission ;
un fil électriquement raccordé à la pluralité d'éléments de génération d'énergie ; et
un boîtier dans lequel la plaque de blindage pour le module de génération d'énergie photovoltaïque à concentrateur, la pluralité d'éléments de génération d'énergie et le fil sont logés.

9. Plaque de blindage pour un module de génération d'énergie photovoltaïque à concentrateur selon la revendication 8, dans laquelle :
le premier trou d'insertion est agencé en étant déplacé du fil dans une direction orthogonale, orthogonale à une direction d'extension dans laquelle le fil s'étend sur une vue en plan, et
le premier trou d'insertion a une forme telle qu'une dimension le long de la direction d'extension est supérieure à une dimension le long de la direction orthogonale.

10. Procédé pour fabriquer le module de génération d'énergie photovoltaïque à concentrateur selon la revendication 8, le procédé comprenant de :
supporter la plaque de blindage pour le module de génération d'énergie photovoltaïque à concentrateur avec une tige de support en insérant la tige de support dans le premier trou d'insertion dans la plaque de blindage pour le module de génération d'énergie photovoltaïque à concentrateur ; et
retirer la plaque de blindage pour le module de génération d'énergie photovoltaïque à concentrateur de la tige de support et agencer la plaque de blindage à l'intérieur du boîtier.
